(19) Europäisches Patentamt
European Patent Office
Office européen des brevets

(11) EP 2 657 011 A1

(12) EUROPEAN PATENT APPLICATION
published in accordance with Art. 153(4) EPC

(43) Date of publication:
30.10.2013 Bulletin 2013/44

(51) Int Cl.:
B32B 7/02 (2006.01)   B32B 9/00 (2006.01)
C03C 17/34 (2006.01)   H01L 31/042 (2006.01)

(21) Application number: 11852140.0

(22) Date of filing: 22.12.2011

(86) International application number:
PCT/JP2011/079922

(87) International publication number:
WO 2012/086806 (28.06.2012 Gazette 2012/26)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 24.12.2010 JP 2010288134

(71) Applicant: Asahi Glass Company, Limited
Tokyo 100-8405 (JP)

(72) Inventors:
• KAWAI, Yohei
  Tokyo 100-8405 (JP)
• YONEDA, Takashige
  Tokyo 100-8405 (JP)

(74) Representative: Müller-Boré & Partner
Patentanwälte
Grafinger Straße 2
81671 München (DE)

(54) ARTICLE HAVING LOW REFLECTION FILM

(57) Provided is an article having a low reflection film which has a low reflectance over a wide wavelength range, has a relatively low reflectance with light having a large incident angle and has good weather resistance and durability. An article having a low reflection film 14 on a transparent substrate 12, wherein the low reflection film 14 comprises two layers which are a lower layer 16 on the transparent substrate 12 side and an upper layer 18 formed on the lower layer 16, and wherein the lower layer 16 has a refractive index of from 1.3 to 1.44, and the upper layer 18 has a refractive index of from 1.10 to 1.29.

Fig. 1

**Description**

TECHNICAL FIELD

The present invention relates to an article having a low reflection film on a transparent substrate.

BACKGROUND ART

An article having a low reflection film on a surface of a transparent substrate is used for e.g. cover glasses for solar cells, various displays or their front plates, various window glasses, cover glasses for touch panels, etc.
As low reflection films, the following ones are, for example, known.

(1) A single-layered low reflection film comprising hollow $SiO_2$ fine particles and a matrix (Patent Document 1).
(2) A low reflection film comprising three or more thin film layers, wherein the refractive indices of the respective layers are made to stepwisely increase from the outermost layer towards the substrate within a range of from 1.0 to 2.5.

However, the low reflection film (1) has the following problems.

· An average reflectance in a wavelength range of from 400 to 1,200 nm is high with respect to light that enters obliquely (i.e. light having a large incident angle).
· In order to suppress the reflectance to be low, it is necessary to lower the refractive index i.e. to increase the porosity, but voids are likely to be formed which communicate from the outermost surface to the transparent substrate. Accordingly, moisture, etc. are likely to penetrate to the transparent substrate, whereby the weather resistance tends to be low.

Whereas, the low reflection film (2) has the following problems.

• It comprises three or more thin film layers, whereby the number of interlayer interfaces is large. As the number of interfaces is large, the frequency of interlayer peeling at the interfaces tends to be high, whereby the abrasion resistance tends to be low.

PRIOR ART DOCUMENTS

PATENT DOCUMENTS

Patent Document 1: JP- A- 2001- 233611
Patent Document 2: JP- A- 2007- 052345

DISCLOSURE OF INVENTION

TECHNICAL PROBLEM

The present invention is to provide an article having a low reflection film which has a low reflectance in a wide wavelength range, has a relatively low reflectance with light having a large incident angle and has good weather resistance and durability.

SOLUTION TO PROBLEM

The article of the present invention is an article having a low reflection film on a transparent substrate, wherein the low reflection film comprises two layers which are a lower layer on the transparent substrate side and an upper layer formed on the lower layer, and wherein the lower layer has a refractive index of from 1.30 to 1.44, and the upper layer has a refractive index of from 1.10 to 1.29.
The lower layer preferably has closed voids and does not have voids communicating from the upper layer side to the transparent substrate side, of the lower layer.
The lower layer is preferably a layer containing $SiO_2$ as the main component.
The upper layer is preferably a layer containing $SiO_2$ as the main component.

The lower layer preferably contains hollow $SiO_2$ fine particles.

The upper layer preferably contains hollow $SiO_2$ fine particles.

The difference between the refractive index of the lower layer and the refractive index of the upper layer is preferably from 0.10 to 0.30.

The lower layer preferably has a porosity of from 10 to 30 vol%.

The lower layer preferably has a thickness of from 50 to 150 nm.

The upper layer preferably has a thickness of from 50 to 300 nm.

The lower layer preferably has closed voids, and the average void diameter of the closed voids is preferably from 10 to 100 nm.

The article of the present invention is preferably a cover glass for a solar cell.

The expression " to " representing the above numerical value range is used to include the numerical values before and after " to " as the lower limit value and the upper limit value, respectively, and hereinafter in this specification, " to " is used to have the same meaning unless otherwise specified.

ADVANTAGEOUS EFFECTS OF INVENTION

The article of the present invention has a low reflectance in a wide wavelength range, has a relatively low reflectance with light having a large incident angle and has good weather resistance and durability.

BRIEF DESCRIPTION OF DRAWINGS

Fig. 1 is a cross-sectional view illustrating an example of the article of the present invention.

Fig. 2 is a scanning electron microscopic photograph of a part of the cross section of the article in Example 1.

DESCRIPTION OF EMBODIMENTS

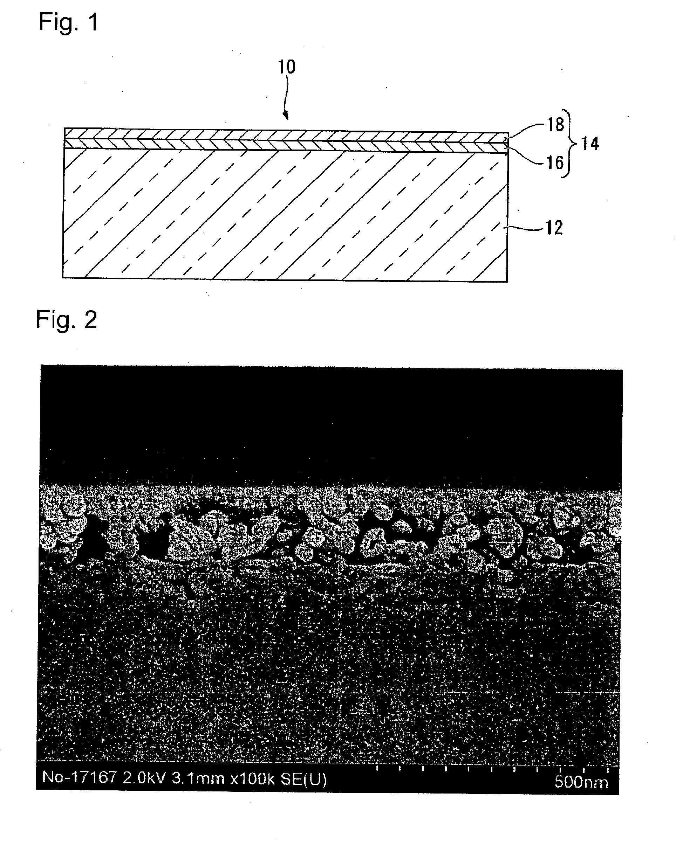

Fig. 1 is a cross-sectional view illustrating an example of the article of the present invention. The article 10 comprises a transparent substrate 12 and a low reflection film 14 formed on a surface of the transparent substrate 12.

(Transparent substrate)

In the transparent substrate, transparent means to transmit at least 80% on average of light in a wavelength range of from 400 to 1,200 nm.

The shape of the transparent substrate may, for example, be a plate, a sheet or a film.

On a surface of the transparent substrate, a layer other than the low reflection film of the present invention, such as an alkali barrier layer, adhesion-improving layer, durability-improving layer or other functional layers, may preliminarily be formed within a range not to present an influence to the performance of the article having the low reflection film.

The material for the transparent substrate may, for example, be glass or a resin.

The glass may, for example, be soda lime glass, borosilicate glass, aluminosilicate glass or alkali-free glass. Further, it may be a smooth glass formed by e.g. a float process, or a template glass having roughness on its surface.

The resin may, for example, be polyethylene terephthalate, polycarbonate, triacetylcellulose or polymethyl methacrylate.

In a case where the transparent substrate is a window glass for buildings or vehicles, soda lime glass having the following composition is preferred.

It comprises, as represented by mass percentage based on oxides,

from 65 to 75% of $SiO_2$,

from 0 to 10% of $Al_2O_3$,

from 5 to 15% of CaO,

from 0 to 15% of MgO,

from 10 to 20% of $Na_2O$,

from 0 to 3% of $K_2O$,

from 0 to 5% of $Li_2O$,

from 0 to 3% of $Fe_2O_3$,

from 0 to 5% of $TiO_2$,

from 0 to 3% of $CeO_2$,

from 0 to 5% of BaO,

from 0 to 5% of SrO,
from 0 to 15% of $B_2O_3$,
from 0 to 5% of ZnO,
from 0 to 5% of $ZrO_2$,
from 0 to 3% of $SnO_2$, and
from 0 to 0.5% of $SO_3$.

In a case where the transparent substrate is alkali-free glass, one having the following composition is preferred.

It comprises, as represented by mass percentage based on oxides,
from 39 to 70% of $SiO_2$,
from 3 to 25% of $Al_2O_3$,
from 1 to 30% of $B_2O_3$,
from 0 to 10% of MgO,
from 0 to 17% of CaO,
from 0 to 20% of SrO, and
from 0 to 30% of BaO.

In a case where the transparent substrate is a mixed alkali type glass, one having the following composition is preferred.

It comprises, as represented by mass percentage based on oxides,
from 50 to 75% of $SiO_2$,
from 0 to 15% of $Al_2O_3$,
from 6 to 24% of MgO+CaO+SrO+BaO+ZnO, and
from 6 to 24% of $Na_2O+K_2O$.

In a case where the transparent substrate is a cover glass for a solar cell, a template glass having surface roughness is preferred. As such a template glass, preferred is a highly transparent high transmittance glass (white plate glass) having an iron component ratio lower than soda lime glass (blue plate glass: popular name for lightly bluish soda lime glass) to be commonly used for e.g. window glass. Here, so-called white plate glass is meant for glass having a transmittance in a wavelength range of from 400 to 800 nm higher than soda lime glass. For example, it is meant for glass having a transmittance of at least 90% in a wavelength range of from 400 to 800 nm when the glass plate is 4 mm.

(Low reflection film)

The low reflection film 14 comprises two layers which are a lower layer 16 on the transparent substrate 12 side and an upper layer 18 formed on the lower layer 16 in contact with the lower layer 16 surface. The lower layer 16 has a refractive index of from 1.30 to 1.44, and the upper layer 18 has a refractive index of from 1.10 to 1.29.

In order to obtain the refractive index n of each layer constituting the low reflection film 14, a single-layered film of the layer, of which the refractive index n is to be obtained, is formed on a surface of a transparent substrate, and with respect to the single-layered film, the minimum reflectance (so-called bottom reflectance) Rmin in a wavelength range of from 300 to 1,200 nm is measured by a spectrophotometer. And, the refractive index n is calculated by the following formula (1) from the minimum reflectance Rmin and the refractive index ns of the transparent substrate.

$$Rmin=(n-ns)^2/(n+ns)^2 \qquad (1)$$

The difference between the refractive index of the lower layer 16 and the refractive index of the upper layer 18 is preferably from 0.10 to 0.30, more preferably from 0.14 to 0.24. When the difference in the refractive index is at least 0.10, the reflection with respect to light having a large incident angle can sufficiently be suppressed. If the difference in the refractive index is at most 0.30, the reflection at the interface between the lower layer 16 and the upper layer 18 can sufficiently be suppressed.

(Lower layer)

The refractive index of the lower layer 16 is from 1.30 to 1.44, preferably from 1.31 to 1.42, more preferably from 1.32 to 1.38. If the refractive index of the lower layer 16 is less than 1.30, the porosity of the lower layer 16 tends to be high, and moisture, etc. tend to penetrate to the transparent substrate 12, whereby weather resistance tends to decrease. If the refractive index of the lower layer 16 exceeds 1.44, the porosity of the lower layer 16 tends to be too low, and the lower layer 16 tends to be dense, whereby warpage is likely to occur in the transparent substrate 12.

The lower layer 16 preferably has closed voids and does not have voids communicating from the upper layer 18 to the transparent substrate 12. When voids in the lower layer 16 are not voids communicating from the upper layer 18 side to the transparent substrate 12 side of the lower layer 16 and are mostly closed independent voids, moisture, etc. tend to hardly penetrate to the transparent substrate 12, whereby the weather resistance will be improved.

The average void diameter of the voids in the lower layer 16 is preferably from 10 to 100 nm, more preferably from 20 to 70 nm. When the average void diameter is at least 10 nm, the refractive index of the lower layer 16 can easily be made to be at most 1.44. When the average void diameter is at most 100 nm, moisture, etc. tend to hardly penetrate to the transparent substrate 12, whereby the weather resistance will be improved.

The average void diameter is obtained by averaging diameters of 100 voids measured from an image obtainable by observing the cross section of the lower layer film by a scanning electron microscope.

The porosity of the lower layer 16 is preferably from 10 to 30 vol%, more preferably from 13 to 20 vol%. When the porosity is at least 10 vol%, the refractive index of the lower layer 16 can easily be made to be at most 1.44. If the porosity is at most 30 vol%, moisture, etc. tend to hardly penetrate to the transparent substrate 12, whereby the weather resistance will be improved.

The porosity is calculated from values obtained by measuring the areas of voids from an image obtainable by observing a cross section of a transparent substrate provided with a low reflection film by a scanning electron microscope.

The thickness of the lower layer 16 is preferably from 50 to 150 nm, more preferably from 60 to 140 nm. When the thickness of the lower layer 16 is at least 50 nm, moisture, etc. tend to hardly penetrate to the transparent substrate 12, whereby the weather resistance will be improved. When the thickness of the lower layer 16 is at most 150 nm, the reflectance with respect to light having a wavelength of from 400 to 1,200 nm can be suppressed to be low.

The thickness of the lower layer 16 is measured from an image obtainable by observing a cross section of a low reflection film by a scanning electron microscope.

The lower layer 16 is preferably a layer containing $SiO_2$ as the main component, more preferably a layer composed substantially of $SiO_2$, from such a viewpoint that the refractive index is relatively low, the chemical stability is excellent, and the adhesion to glass is excellent. The layer containing $SiO_2$ as the main component means that the proportion of $SiO_2$ is at least 90 mass% in the lower layer 16 (100 mass%), and the layer composed substantially of $SiO_2$ means that it is constituted solely by $SiO_2$ except for unavoidable impurities.

The lower layer 16 is preferably composed of $SiO_2$ fine particles and a matrix.

The $SiO_2$ fine particles may be hollow $SiO_2$ fine particles or solid $SiO_2$ fine particles, and they are preferably hollow $SiO_2$ fine particles, since it is thereby possible to form á lower layer 16 having closed voids and not having voids communicating from the upper layer 18 to the transparent substrate 12.

The hollow $SiO_2$ fine particles may be present in such a state that the respective particles are independent of one another, the respective particles may be linked in a chain form, or the respective particles are agglomerated to one another.

The average primary particle size of the hollow $SiO_2$ fine particles is preferably from 5 to 150 nm, more preferably from 50 to 100 nm. When the average primary particle size of the hollow $SiO_2$ fine particles is at least 5 nm, the reflectance of the low reflection film 14 will be sufficiently low. When the average primary particle size of the hollow $SiO_2$ fine particles is at most 150 nm, the haze of the low reflection film 14 can be suppressed to be low.

The solid $SiO_2$ fine particles may be present in a state where the respective particles are independent of one another, the respective particles may be linked in a chain form, or the respective particles may be agglomerated to one another.

The average primary particle size of the solid $SiO_2$ fine particles is preferably from 5 to 150 nm, more preferably from 50 to 100 nm. When the average primary particle size of the solid $SiO_2$ fine particles is at least 5 nm, the reflectance of the low reflection film 14 will be sufficiently low. When the average primary particle size of the solid $SiO_2$ fine particles is at most 150 nm, the haze of the low reflection film 14 can be suppressed to be low.

The average primary particle size is obtained by randomly selecting 100 fine particles from an electron microscopic photograph, measuring the particle sizes of the respective fine particles and averaging the particle sizes of the 100 fine particles.

The matrix may, for example, be a fired product of a hydrolyzate of an alkoxysilane (sol-gel silica), a fired product of a silazane or the like, but is more preferably a fired product of a hydrolyzate of an alkoxysilane. As a catalyst to be used for the hydrolysis of an alkoxysilane, one not to prevent dispersion of the hollow $SiO_2$ fine particles is preferred.

The alkoxysilane may, for example, be a tetraalkoxysilane (such as tetramethoxysilane, tetraethoxysilane, tetrapropoxysilane or tetrabutoxysilane), an alkoxysilane having a perfluoropolyether group (such as a perfluoropolyether triethoxysilane), an alkoxysilane having a perfluoroalkyl group (such as a perfluoroethyl triethoxysilane), an alkoxysilane having a vinyl group (such as vinyltrimethoxysilane or vinyltriethoxysilane), an alkoxysilane having an epoxy group (such as 2- (3, 4- epoxycyclohexyl) ethyltrimethoxysilane, 3- glycidoxypropyl trimethoxysilane, 3- glycidoxypropylmethyl diethoxysilane or 3- glycidoxypropyl triethoxysilane) or an alkoxysilane having an acryloyloxy group (such as 3- acryloyloxypropyl trimethoxysilane) .

The hydrolysis of an alkoxysilane is carried out, in the case of a tetraalkoxysilane, by using water in an amount of 4 times by mole of the alkoxysilane, and an acid or alkali as a catalyst. The acid may, for example, be an inorganic acid (such as $HNO_3$, $H_2SO_4$ or $HCl$) or an organic acid (such as formic acid, oxalic acid, monochloroacetic acid, dichloroacetic acid or trichloroacetic acid). The alkali may, for example, be ammonia, sodium hydroxide or potassium hydroxide. As the catalyst, an acid is preferred from the viewpoint of a long term storage stability of the hydrolyzate of an alkoxysilane.

(Upper layer)

The refractive index of the upper layer 18 is from 1.10 to 1.29, preferably from 1.12 to 1.27, more preferably from 1.15 to 1.25. If the refractive index of the upper layer 18 is less than 1.10, the upper layer 18 tends to be too loose, whereby the durability tends to be low. If the refractive index of the upper layer 18 exceeds 1.29, the reflectance of the low reflection film tends to be high.

The thickness of the upper layer 18 is preferably from 50 to 300 nm, more preferably from 100 to 250 nm. When the thickness of the upper layer 18 is at least 50 nm, it is possible to suppress the reflectance to be low with respect to light having a wavelength of from 400 to 1,200 nm. When the thickness of the upper layer 18 is at most 300 nm, it is possible to secure practical abrasion resistance.

The thickness of the upper layer 18 is measured from an image obtainable by observing a cross section of a low reflection film by a scanning electron microscope.

The upper layer 18 is preferably a layer containing $SiO_2$ as the main component, more preferably a layer composed substantially of $SiO_2$, from such a viewpoint that the refractive index is relatively low, the chemical stability is excellent and the adhesion to the lower layer 16 is excellent.

The upper layer 18 is preferably composed of $SiO_2$ fine particles and a matrix.

The $SiO_2$ fine particles may be hollow $SiO_2$ fine particles or solid $SiO_2$ fine particles, and they are preferably hollow $SiO_2$ fine particles, since a low refractive index is required for the upper layer 18.

As the hollow $SiO_2$ fine particles, the solid $SiO_2$ fine particles and the matrix, the same ones as used in the lower layer 16 may be employed.

(Process for producing article)

The article of the present invention can be produced, for example, by sequentially applying coating fluids to form the respective layers on a transparent substrate, pre-heating them as the case requires and finally firing them. In the present invention, "firing" includes curing treatment by heating a coating film obtained by applying a coating fluid on a transparent substrate surface.

The coating fluid may, for example, be a mixture of a dispersion of $SiO_2$ fine particles and a solution of a matrix precursor (such as a solution of a hydrolyzate of an alkoxysilane or a solution of a silazane).

The coating fluid may contain a surfactant to improve the leveling property, a metal compound to improve the durability of the coating film, etc.

The dispersing medium for the dispersion of $SiO_2$ fine particles may, for example, be water, an alcohol, a ketone, an ether, a cellosolve, an ester, a glycol ether, a nitrogen-containing compound or a sulfur-containing compound.

The solvent for the solution of the hydrolyzate of an alkoxysilane, is preferably a mixed solvent of water and an alcohol (such as methanol, ethanol, isopropanol, butanol or diacetone alcohol).

The coating method may be a known wet coating method (such as a spin coating method, a spray coating method, a dip coating method, a die coating method, a curtain coating method, a screen coating method, an ink jet method, a flow coating method, a gravure coating method, a bar coating method, a flexo coating method, a slit coating method or a roll coating method).

The coating temperature is preferably from room temperature to 200°C, more preferably from room temperature to 150°C.

The firing temperature is preferably at least 30°C and may suitably be determined depending upon the material for the transparent substrate, the fine particles or the matrix.

For example, in a case where the material for the transparent substrate is a resin, the firing temperature is at most the heat resistant temperature of the resin, and a sufficient reflection-preventing effect can be obtained even at such a temperature.

In a case where the transparent substrate is glass, the firing temperature is from 200°C to at most the softening point temperature. When the firing temperature is at least 200°C, the lower layer can be densified to improve the durability. When the firing temperature is at most the softening point temperature (e.g. at most 800°C) of glass, the reflectance of the low reflection film can be made to be sufficiently low without diminishing voids in the low reflection film.

(Advantageous effects)

The article of the present invention as described above, has a double-layered structure comprising a lower layer having a refractive index of from 1.30 to 1.44 and an upper layer having a refractive index of from 1.10 to 1.29 sequentially from the transparent substrate side, whereby the reflectance is low in a wide wavelength range, and the reflectance of light having a large incident angle is low as compared with a single-layered low reflection film.

Further, in the article of the present invention, the refractive index of the lower layer is from 1.30 to 1.44. That is, the lower layer is a dense layer, whereby moisture, etc. tend to hardly penetrate to the transparent substrate, and the weather resistance is good.

Further, in the article of the present invention, the low reflection film is composed of a two layers, whereby the abrasion resistance is good as compared with a low reflection film composed of three or more layers.

With respect to the wavelength dependency of the reflectance, specifically, the average reflectance within a wavelength range of from 400 to 1,200 nm with respect to light having an incident angle of 5°, is preferably from 0.1 to 1.2%.

With respect to the incident angle dependency of the reflectance, specifically, the average reflectance within a wavelength range of from 400 to 1,200 nm with respect to light having an incident angle of 70°, is preferably from 3.0 to 9.0%.

With respect to the weather resistance, specifically, a change in the average transmittance in a wavelength of from 400 to 1,200 nm with respect to light having an incident angle of 0°, is preferably at most 1.0% as between before and after the after-described moisture resistance test.

With respect to the abrasion resistance, specifically, a change in the average transmittance in a wavelength of from 400 to 1,200 nm with respect to light having an incident angle of 0°, is preferably at most 1.0% as between before and after the after-described abrasion test.

EXAMPLES

Now, the present invention will be described in further detail with reference to Examples.

Examples 1 to 5 are Working Examples of the present invention, and Examples 6 to 10 are Comparative Examples.

(Average primary particle size of fine particles)

With respect to the average primary particle size of hollow fine particles, a dispersion of hollow fine particles was diluted to 0.1 mass% with ethanol, then sampled on a collodion film and observed by a transmission electron microscope (H-9000, manufactured by Hitachi, Ltd.), whereby 100 hollow fine particles were randomly selected, and the particle sizes of the respective fine particles were measured, whereupon the average primary particle size of hollow fine particles was obtained by averaging the particle sizes of the 100 fine particles.

With respect to the average primary particle size of fine particles other than hollow fine particles, on the assumption that spherical particles are uniformly dispersed in a carrier, the average primary particle size was calculated from the specific surface area measured by a BET method and the volume of the spherical particles.

(Outer shell thickness and void diameter of hollow fine particles)

With respect to the outer shell thickness and void diameter of hollow fine particles, a dispersion of hollow fine particles was diluted to 0.1 mass% with ethanol, then sampled on a collodion film and observed by a transmission electron microscope (H-9000, manufactured by Hitachi, Ltd.), whereby 100 hollow fine particles were randomly selected, and the outer shell thicknesses and void diameters of the respective hollow fine particles were measured, whereupon the outer shell thickness and void diameter of the hollow fine particles were obtained by averaging the outer shell thicknesses and void diameters, respectively, of the 100 hollow fine particles.

(Refractive index)

With respect to the refractive index of a low reflection film, a translucent substrate provided with a low reflection film was measured by an ellipsometer (model: M-2000DI, manufactured by J.A. Woollam), and the refractive index at a wavelength of 550 nm was obtained.

(Porosity)

The porosity of a low reflection film was calculated from values obtained by measuring areas of voids from an image obtainable by observing a cross section of a translucent substrate provided with a low reflection film by a scanning electron microscope (model: S-4300, manufactured by Hitachi, Ltd.).

(Void-form)

The void-form in the low reflection film was specified by an image obtainable by observing a cross section of a translucent substrate provided with a low reflection film by a scanning electron microscope (model: S-4300, manufactured by Hitachi, Ltd.).

(Average void diameter)

The average void diameter in a low reflection film was measured from an image obtainable by observing a cross section of a translucent substrate provided with a low reflection film by a scanning electron microscope (model: S-4300, manufactured by Hitachi, Ltd.).

(Film thickness)

The thickness of a low reflection film was measured from an image obtainable by observing the cross section of a translucent substrate provided with a low reflection film by a scanning electron microscope (model: S-4300, manufactured by Hitachi, Ltd.).

(Reflectance)

The reflectance of a translucent substrate provided with a low reflection film was measured by means of a spectrophotometer (model: U-4100, manufactured by Hitachi, Ltd.). Here, the reflectance is an average reflectance in a wavelength range of from 400 to 1,200 nm.

(Transmittance)

The transmittance of a translucent substrate provided with a low reflection film was measured by means of a spectrophotometer (model: U-41 00, manufactured by Hitachi, Ltd.). Here, the transmittance is an average transmittance within a wavelength range of from 400 to 1,200 nm.

(Moisture resistance test)

A translucent substrate provided with a low reflection film was put in a constant temperature constant humidity tank at 80°C under a humidity of 90% and held for 1,000 hours, whereupon the transmittance was measured to obtain an average transmittance within a wavelength range of from 400 to 1,200 nm. From average transmittances before and after the test, the change by the moisture resistance test was obtained.

(Abrasion test)

The surface of a translucent substrate provided with a low reflection film was reciprocally abraded 1,000 times with a load of 1 kg by a felt, whereupon the transmittance was measured, and an average transmittance within a wavelength range of from 400 to 1,200 nm was obtained. From average transmittances before and after the test, the change by the abrasion test was obtained.

(Dispersion (A) of hollow $SiO_2$ fine particles)

While stirring 59 g of ethanol, 30 g of an aqueous dispersion of ZnO fine particles (solid content concentration: 20 mass%, average primary particle size: 30 nm) and 10 g of tetraethoxysilane (amount of solid content calculated as $SiO_2$: 29 mass%) were added, and then, 1 g of a 28 mass% ammonia aqueous solution was added to adjust the pH of the dispersion to 10, followed by stirring at 20°C for 6 hours to obtain 100 g of a dispersion of core-shell fine particles (solid content concentration: 6 mass%).

To the obtained dispersion of core-shell fine particles, 100 g of a strongly acidic cation exchange resin (DIAION, manufactured by Mitsubishi Chemical Corporation, total exchange amount: at least 2.0 mseq/mL) was added, followed by stirring for 1 hour, and after the pH became 4, the strongly acidic cation resin was removed by filtration, and the dispersion was subjected to ultrafiltration to obtain a dispersion (A) of hollow $SiO_2$ fine particles having a solid content concentration as calculated as $SiO_2$ of 15 mass%. The outer shell thickness of the hollow $SiO_2$ fine particles was 8 nm, the void diameter was 26 nm, and the average primary particle size was 42 nm.

(Dispersion (B) of hollow $SiO_2$ fine particles)

While stirring 49.5 g of ethanol, 45 g of an aqueous dispersion of ZnO fine particles (solid content concentration: 20 mass%, average primary particle size: 80 nm) and 5 g of tetraethoxysilane (amount of solid content calculated as $SiO_2$: 29 mass%) were added, and then, 0.5 g of a 28 mass% ammonia aqueous solution was added to adjust the pH of the dispersion to 10, followed by stirring at 20°C for 6 hours to obtain 100 g of a dispersion of core-shell fine particles (solid content concentration: 10.5 mass%).

To the obtained dispersion of core-shell fine particles, 200 g of a strongly acidic cation exchange resin (DIAION, manufactured by Mitsubishi Chemical Corporation, total exchange amount: at least 2.0 mseq/mL) was added, followed by stirring for 1 hour, and after the pH became 4, the strongly acidic cation resin was removed by filtration to obtain a dispersion (B) of hollow $SiO_2$ fine particles having a solid content concentration as calculated as $SiO_2$ of 15 mass%. The outer shell thickness of the hollow $SiO_2$ fine particles was 4 nm, the void diameter was 66 nm, and the average primary particle size was 74 nm.

(Dispersion (C) of chain-form solid $SiO_2$ fine particles)

IPA- ST- UP (tradename), manufactured by Nissan Chemical Industries, Ltd., solid content concentration as calculated as $SiO_2$: 15 mass%, primary particle size: from 5 to 40 nm, dispersing medium: isopropanol.

(Solution (D) of matrix precursor)

COLCOAT P (tradename), manufactured by COLCOAT CO., LTD., solution of a hydrolyzate of an alkoxysilane, solid content concentration calculated as $SiO_2$: 2 mass%, ethanol: 4 mass%, isopropanol: 40 mass%, n- butanol: 50 mass%, water: 4 mass%.

[Example 1]

While stirring 78.0 g of ethanol, 12.0 g of the dispersion (A) of hollow $SiO_2$ fine particles and 10.0 g of the solution (D) of the matrix precursor were added thereto to prepare a coating fluid for an upper layer having a solid content concentration of 2.0 mass%. This composition is shown in Table 1. Further, on a surface of a glass plate (refractive index ns: 1.53), the coating fluid for an upper layer was applied and fired under the same conditions as the after-described conditions for forming an upper layer to form a single layered film, whereupon the refractive index, the film thickness, the reflectance, the transmittance, the changes in transmittance after the moisture resistance test and after the abrasion test, other properties, etc. were obtained. The results are shown in Table 2.

While stirring 66.4 g of ethanol, 5.6 g of the dispersion (A) of hollow $SiO_2$ fine particles and 28.0 g of the solution (D) of the matrix precursor were added thereto to prepare a coating fluid for a lower layer having a solid content concentration of 1.4 mass%. The composition is shown in Table 1. Further, on a surface of a glass plate (refractive index ns: 1.53), the coating fluid for an upper layer was applied and fired under the same conditions as the after-described conditions for forming a lower layer to form a single layered film, whereupon the refractive index and the film thickness were obtained. The results are shown in Table 2.

As a transparent substrate, a template glass (Solite, manufactured by Asahi Glass Company, Limited, soda lime glass (popular name: white plate glass) as high transmittance glass having a low iron content, size: 100 mm × 100 mm, thickness: 3.2 mm) was prepared, and the surface of the template glass was polished with an aqueous dispersion of cerium oxide. Cerium oxide was washed off with water, followed by rinsing with ion exchanged water and then by drying.

On a surface of the template glass, the coating fluid for a lower layer was applied by spin coating (at 500 rpm for 20 seconds). After the application, the template glass was pre-heated in a pre-heating furnace, and then the coating fluid for an upper layer was further applied by spin coating (at 500 rpm for 20 seconds). Then, firing was carried out at 650°C for 10 minutes to obtain an article having a low reflection film formed. The article was evaluated. The results are shown in Table 2.

[Examples 2 to 9]

An article having a low reflection film formed, was obtained in the same manner as in Example 1 except that the composition of the coating fluid was changed to the composition shown in Table 1. The article was evaluated. The results are shown in Table 2.

Further, a scanning electron microscopic photograph of a cross section of the article in Example 1 is shown in Fig. 2.

[Example 10]

An article having a low reflection film formed, was obtained in the same manner as in Example 1 except that three types of coating fluids for a lower layer, an intermediate layer and an upper layer were prepared as shown in Table 1, and an intermediate layer is formed between the upper layer and the lower layer. The article was evaluated. The results are shown in Table 2.

Table 1

|  |  |  | Ex. 1 | Ex. 2 | Ex. 3 | Ex. 4 | Ex. 5 | Ex. 6 | Ex. 7 | Ex. 8 | Ex. 9 | Ex. 10 |
|---|---|---|---|---|---|---|---|---|---|---|---|---|
| Upper layer coating fluid | Dispersion of fine particles | Type | A | B | B | B | A | A | A | A | A | B |
|  |  | Mass (g) | 12.0 | 8.4 | 11.7 | 6.0 | 11.3 | 10.8 | 7.2 | 9.6 | 9.0 | 7.9 |
|  | Matrix precursor | Type | D | D | D | D | D | D | D | D | D | D |
|  |  | Mass (g) | 10.0 | 27.0 | 37.5 | 30.0 | 15.0 | 9.0 | 6.0 | 8.0 | 7.5 | 25.5 |
|  | Ethanol | Mass (g) | 78.0 | 64.6 | 50.8 | 64.0 | 73.7 | 80.2 | 86.8 | 82.4 | 83.5 | 66.6 |
|  | Total | Mass (g) | 100.0 | 100.0 | 100.0 | 100.0 | 100.0 | 100.0 | 100.0 | 100.0 | 100.0 | 100.0 |
|  | Solid content (%) |  | 2.0 | 1.8 | 2.5 | 1.5 | 2.0 | 1.8 | 1.2 | 1.6 | 1.5 | 1.7 |
| Intermediate layer coating fluid | Dispersion of fine particles | Type | - | - | - | - | - | - | - | - | - | A |
|  |  | Mass (g) | - | - | - | - | - | - | - | - | - | 4.5 |
|  | Matrix precursor | Type | - | - | - | - | - | - | - | - | - | D |
|  |  | Mass (g) | - | - | - | - | - | - | - | - | - | 6.0 |
|  | Ethanol | Mass (g) | - | - | - | - | - | - | - | - | - | 89.5 |
|  | Total | Mass (g) | - | - | - | - | - | - | - | - | - | 100.0 |
|  | Solid content (%) |  | - | - | - | - | - | - | - | - | - | 0.8 |
| Lower layer coating fluid | Dispersion of fine particles | Type | A | A | A | B | A | - | A | - | C | A |
|  |  | Mass (g) | 5.6 | 5.0 | 6.0 | 5.6 | 2.7 | - | 4.3 | - | 2.7 | 4.0 |
|  | Matrix precursor | Type | D | D | D | D | D | - | D | D | D | D |
|  |  | Mass (g) | 28.0 | 37.5 | 45.0 | 28.0 | 20.0 | - | 8.0 | 100.0 | 20.0 | 30.0 |
|  | Ethanol | Mass (g) | 66.4 | 57.5 | 49.0 | 66.4 | 77.3 | - | 87.7 | 0.0 | 77.3 | 66.0 |
|  | Total | Mass (g) | 100.0 | 100.0 | 100.0 | 100.0 | 100.0 | - | 100.0 | 100.0 | 100.0 | 100.0 |
|  | Solid content (%) |  | 1.4 | 1.5 | 1.8 | 1.4 | 0.8 | - | 0.8 | 2.0 | 0.8 | 1.2 |

Table 2

| | | Ex. 1 | Ex. 2 | Ex. 3 | Ex. 4 | Ex. 5 | Ex. 6 | Ex. 7 | Ex. 8 | Ex. 9 | Ex. 10 |
|---|---|---|---|---|---|---|---|---|---|---|---|
| Film thickness (nm) | Upper layer | 172 | 122 | 202 | 108 | 140 | 122 | 84 | 104 | 91 | 112 |
| | Intermediate layer | - | - | - | - | - | - | - | - | - | 46 |
| | Lower layer | 89 | 104 | 135 | 93 | 55 | - | 48 | 96 | 52 | 88 |
| Refractive index | Upper layer | 1.24 | 1.14 | 1.14 | 1.18 | 1.26 | 1.24 | 1.24 | 1.24 | 1.24 | 1.14 |
| | Intermediate layer | - | - | - | - | - | - | - | - | - | 1.26 |
| | Lower layer | 1.40 | 1.38 | 1.38 | 1.32 | 1.38 | - | 1.28 | 1.46 | 1.40 | 1.38 |
| | Difference in refractive index | 0.16 | 0.24 | 0.24 | 0.14 | 0.12 | - | 0.04 | 0.22 | 0.16 | 0.12 |
| Porosity (%) | Lower layer | 13 | 17 | 18 | 30 | 17 | - | 48 | 0 | - | 18 |
| Void-form | Lower layer | Closed | Closed | Closed | Closed | Closed | - | Closed | Nil | Communicated | Closed |
| Presence or absence of communicating voids | Lower layer | Absent | Absent | Absent | Absent | Absent | - | Absent | Absent | Present | Absent |
| Average void diameter (nm) | Lower layer | 23 | 24 | 22 | 62 | 22 | - | 25 | - | - | 21 |
| Average reflectance (%) | Incident angle of 5° | 0.65 | 0.15 | 1.14 | 0.54 | 1.12 | 0.60 | 0.63 | 0.44 | 0.73 | 0.24 |
| | Incident angle of 70° | 8.91 | 6.54 | 3.21 | 6.64 | 8.24 | 9.29 | 9.10 | 9.98 | 9.23 | 6.20 |
| Average transmittance (%) | Incident angle of 0° | 95.50 | 95.98 | 95.02 | 95.61 | 95.03 | 95.52 | 95.55 | 95.71 | 95.36 | 95.89 |
| Average transmittance after moisture resistance test (%) | Incident angle of 0° | 95.13 | 95.52 | 94.39 | 94.92 | 94.24 | 93.24 | 94.42 | 95.43 | 94.24 | 95.56 |
| | Change | 0.37 | 0.46 | 0.63 | 0.69 | 0.79 | 2.28 | 1.13 | 0.28 | 1.12 | 0.33 |

(continued)

| | | Ex. 1 | Ex. 2 | Ex. 3 | Ex. 4 | Ex. 5 | Ex. 6 | Ex. 7 | Ex. 8 | Ex. 9 | Ex. 10 |
|---|---|---|---|---|---|---|---|---|---|---|---|
| Average transmittance after abrasion test (%) | Incident angle of 0° | 95.14 | 95.52 | 94.44 | 95.17 | 94.75 | 95.35 | 95.24 | 95.33 | 94.86 | 94.77 |
| | Change | 0.36 | 0.46 | 0.58 | 0.44 | 0.28 | 0.17 | 0.31 | 0.38 | 0.50 | 1.12 |

In Example 6, the low reflection film is single layered, whereby the average reflectance in a wavelength range of from 400 to 1,200 nm is high with respect to light at an incident angle of 70°. Further, moisture, etc. are likely to penetrate to the transparent substrate, whereby the weather resistance is low.

In Example 7, the refractive index of the lower layer is too low, whereby the average reflectance in a wavelength range of from 400 to 1,200 nm is high with respect to light at an incident angle of 70°. Further, moisture, etc. are likely to penetrate to the transparent substrate, whereby the weather resistance is low.

In Example 8, the refractive index of the lower layer is too high, whereby the average reflectance in a wavelength range of from 400 to 1,200 nm is high with respect to light at an incident angle of 70°. Further, the transparent substrate undergoes warpage.

In Example 9, the lower layer has voids communicating to the upper layer, whereby moisture, etc. are likely to penetrate to the transparent substrate, and the weather resistance is low.

In Example 10, the low reflection film is three layered, whereby the abrasion resistance is low.

INDUSTRIAL APPLICABILITY

The article having a low reflection film of the present invention is useful not only for a cover glass for a solar cell, but also for a transparent component for a vehicle (such as a headlight cover, a side mirror, a front transparent substrate, a side transparent substrate or a rear transparent substrate), a transparent component for a vehicle (such as an instrument panel surface), various meters, a building window, a show window, a display (such as a notebook-size personal computer, a monitor, LCD, PDP, ELD, CRT or PDA), an LCD color filter, a touch panel substrate, a pickup lens, an optical lens, an eyeglass lens, a camera component, a video component, a cover substrate for CCD, an optical fiber, a projector component, a copying machine component, a transparent substrate for a solar cell, a cellphone window, a backlight unit component (such as a light guide panel or a cold-cathode tube), a backlight unit component liquid crystal luminance-improving film (such as a prism or a semitransmissive film), a liquid crystal luminance-improving film, an organic EL light-emitting element component, an inorganic EL light-emitting element component, a phosphor light-emitting element component, an optical filter, other various optical components, an illumination lamp, a cover for a lighting device, an amplification laser light source, an antireflection film, a polarizing film, or an agricultural film.

The entire disclosure of Japanese Patent Application No. 2010-288134 filed on December 24, 2010 including specification, claims, drawings and summary is incorporated herein by reference in its entirety.

Reference symbols

10: article, 12: transparent substrate, 14: low reflection film, 16: lower layer, 18: upper layer

**Claims**

1. An article having a low reflection film on a transparent substrate, wherein the low reflection film comprises two layers having a lower layer on the transparent substrate side and an upper layer formed on the lower layer, and wherein the lower layer has a refractive index of from 1.30 to 1.44, and the upper layer has a refractive index of from 1.10 to 1.29.

2. The article according to Claim 1, wherein the lower layer has closed voids and does not have voids communicating from the upper layer side to the transparent substrate side, of the lower layer.

3. The article according to Claim 1 or 2, wherein the lower layer is a layer containing $SiO_2$ as the main component.

4. The article according to any one of Claims 1 to 3, wherein the upper layer is a layer containing $SiO_2$ as the main component.

5. The article according to any one of Claims 1 to 4, wherein the lower layer contains hollow $SiO_2$ fine particles.

6. The article according to any one of Claims 1 to 5, wherein the upper layer contains hollow $SiO_2$ fine particles.

7. The article according to any one of Claims 1 to 6, wherein the difference between the refractive index of the lower layer and the refractive index of the upper layer is from 0.10 to 0.30.

8. The article according to any one of Claims 1 to 7, wherein the lower layer has a porosity of from 10 to 30 vol%.

9. The article according to any one of Claims 1 to 8, wherein the lower layer has a thickness of from 50 to 150 nm.

10. The article according to any one of Claims 1 to 9, wherein the upper layer has a thickness of from 50 to 300 nm.

11. The article according to any one of Claims 1 to 10, wherein the lower layer has closed voids, and the average void diameter of the closed voids is from 10 to 100 nm.

12. The article according to any one of Claims 1 to 11, which is a cover glass for a solar cell.

Fig. 1

Fig. 2

No-17167 2.0kV 3.1mm x100k SE(U) 500nm

| | INTERNATIONAL SEARCH REPORT | International application No. |
|---|---|---|
| | | PCT/JP2011/079922 |

A.  CLASSIFICATION OF SUBJECT MATTER
*B32B7/02*(2006.01)i, *B32B9/00*(2006.01)i, *C03C17/34*(2006.01)i, *H01L31/042*
(2006.01)i

According to International Patent Classification (IPC) or to both national classification and IPC

B.  FIELDS SEARCHED

Minimum documentation searched (classification system followed by classification symbols)
B32B7/02, B32B9/00, C03C17/34, H01L31/042

Documentation searched other than minimum documentation to the extent that such documents are included in the fields searched
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
JSTPlus/JMEDPlus/JST7580(JDreamII)

C.  DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2006-221144 A  (Pentax Corp.),<br>24 August 2006 (24.08.2006),<br>example 4, table 1; table 4, example 4<br>(Family: none) | 1,4,7,9,10<br>6,12<br>2,3,5,8,11 |
| X<br>Y<br>A | JP 2003-119052 A  (Matsushita Electric Works,<br>Ltd.),<br>23 April 2003 (23.04.2003),<br>paragraph [0031]; table 1, examples 1, 5, 6;<br>fig. 3<br>(Family: none) | 1,3,4,7,9-11<br>5,6,12<br>2,8 |
| Y<br>A | WO 2010/050263 A1  (Asahi Glass Co., Ltd.),<br>06 May 2010 (06.05.2010),<br>paragraph [0079]; claims<br>(Family: none) | 5,6,12<br>1-4,7-11 |

| ☐ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 February, 2012 (27.02.12) | 06 March, 2012 (06.03.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**EP 2 657 011 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001233611 A
- JP 2007052345 A
- JP 2010288134 A